# EUROPEAN PATENT APPLICATION

(11) **EP 1 439 425 A1**
(43) Date of publication of application: **21.07.2004**
(21) Application number: 03257449.3
(22) Date of filing: 26.11.2003
(51) Int. Cl.: G03F 7/20, G03F 1/00, G03F 1/14

(54) **Lithographic projection apparatus and device manufacturing method**

(30) Priority: 27.11.2002 EP 02258163
(71) Applicant: ASML Netherlands B.V., 5503 LA Veldhoven (NL)
(72) Inventor: Bleeker, Arno Jan, 5563 CE Westerhoven (NL)
(74) Representative: Leeming, John Gerard

(57) **Abstract**

Pixel element for an SLM for use with lithographic projection apparatus which can simultaneously modulate both phase and amplitude.

## Description

The present invention relates to a lithographic projection apparatus comprising:
- a radiation system for supplying a projection beam of radiation;
- programmable patterning means for patterning the projection beam according to a desired pattern;
- a substrate table for holding a substrate; and
- a projection system for projecting the patterned beam onto a target portion of the substrate.

Lithographic projection apparatus are used in the manufacture of integrated circuits (ICs), flat panel displays and other devices involving fine structures. The programmable patterning means generates a pattern corresponding to an individual layer of, for example, the IC, and this pattern is imaged onto a target portion (*e.g.* comprising part of, one or several dies) on a substrate (*e.g.* silicon wafer or glass plate) that has been coated with a layer of radiation-sensitive material (resist).

Prior to this imaging step, the substrate may undergo vario us procedures, such as priming, resist coating and a soft bake. After exposure, the substrate may be subjected to other procedures, such as a post-exposure bake (PEB), development, a hard bake and measurement/inspection of the imaged features. These transfer procedures result in a patterned layer of resist on the substrate. One or more pattern steps, such as deposition, etching, ion-implantation (doping), metallization, oxidation, chemo-mechanical polishing, etc., follow, each of which is intended to finish, create or modify a layer of the device. If several layers are required, then the whole procedure, or a variant thereof, is repeated for each new layer. Eventually, an array of devices will be present on the substrate (wafer). These devices are then separated from one another by a technique such as dicing or sawing, whence the individual devices can be mounted on a carrier, connected to pins, etc.. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

In order to optimise the pattern projected onto a substrate using a lithographic projection apparatus it is desirable to be able to produce gray scale exposures. It is also desirable to be able to create a phase difference between adjacent elements. The use of these characteristics enables closer control of the position of the edges of features produced on the substrate. Presently known spatial light modulators can produce gray scale images. Other presently known spatial light modulators can produce phase modulation. However, it would be desirable to form spatial light modulators with even greater control of the image produced.

It is an object of the present invention to provide programmable patterning means with enhanced control of the image that they produce.

This and other objects are achieved according to the invention in a lithographic apparatus as specified in the opening paragraph, characterized in that said programmable patterning means comprises a plurality of individually addressable pixels, each formed from a single discrete element that can be used to modulate both the amplitude and phase of the radiation that is incident on it; and at least one pixel element comprises a layer of electro-optical material and electrodes for selectively applying a voltage to the electro-optical material in order to change its birefringence.

A lithographic apparatus with a programmable patterning means can therefore produce devices on a substrate with features which have edges which are more closely controlled. Consequently the quality of the features is increased.

At least one of the pixel elements comprises a layer of electro-optical material and electrodes for selectively applying a voltage to the electro-optical material in order to change its birefringence. The birefringence of the material causes the polarization of radiation passing through it to change. The degree of change of the polarization is dependent on the birefringence of the material which, in turn, is dependent on the voltage applied to the electro-optical material. Therefore, by illuminating the programmable patterning means with polarized light and passing the light emitted from the programmable patterning means through a polarizing filter prior to it being projected onto the substrate, the amplitude of the light from each pixel may be modulated.

The pixel element may contain a second layer of electro-optical material with electrodes for applying a second voltage to the second electro-optical material layer in order to change its birefringence. The direction of the extraordinary axis of the second layer is perpendicular to the direction of the extraordinary axis of the first layer of electro-optical material. The directions of the ordinary axes of both layers are generally parallel to the beam of radiation that is incident on the programmable patterning means. The second layer of electro-optical material will, if the voltage applied to the first and second layers is the same, compensate for the change in polarization of the first electro-optical layer. Any difference between the voltages applied to the first and second electro-optical material layer will result in a net change of polarization of the beam of radiation emitted from the pixel with respect to the beam of radiation incident upon it. Therefore, by use of an appropriate polarizing filter, the radiation can be amplitude modulated by the pixel element. The birefringence of the electro-optical layer also results in a phase change of the radiation. However, the phase change produced by the two layers is cumulative, namely the phase change produced by one layer does not compensate for the phase change produced by the other layer. Therefore the pixel element may also be used to phase modulate the beam of radiation. When little or no voltage is applied to both layers, there is effectively no phase change to the radiation and no change in polarization. If voltage is applied to one of the two layers, the phase and the polarization of the beam of radiation is changed. If voltage is applied to both layers, then the phase of the radiation will be changed but the polarization will not change. It is therefore possible to modulate the phase and amplitude of the radiation independently.

In an alternative embodiment, the pixel element comprises a single layer of electro-optical material for adjusting the polarization of the radiation, and hence amplitude modulating the radiation. This is mounted on an actuator for adjusting the position of the pixel element in a direction parallel to the beam of radiation incident on it. Adjusting the position of the pixel element can therefore be used to phase modulate the radiation.

These embodiments may be used to provide transmissive SLMs. Alternatively, by attaching a layer of reflective material to the electro-optical material for reflecting the radiation transmitted through the electro-optical material, a reflective SLM can be provided.

Preferably the electro-optical material is formed from one of ADP, AD*P, KDT and KD*P. For optimum control of the electro-optical material, it should be operated at close to, but just above, the Curie temperature. Temperature controlled cooling means may therefore provided in the SLM.

The electro-optical materials which are used in the present invention have some similar properties to liquid crystal devices used in displays commonly referred to as LCDs. However, the electro-optical materials are in a solid state rather than liquid. The advantage of such electro-optical materials are that they do not degrade as liquid crystals do in the presence of UV and DUV radiation; the electro-optical materials can switch to a different state at a much faster rate (potentially at GHz rate whereas liquid crystal devices can typically only switch at rates of up to 4kHz); devices made from electro-optical material can be manufactured using lithography techniques; and electro-optical devices can therefore be potentially made in much smaller sizes than corresponding liquid crystal devices.

According to a further aspect of the invention there is provided:
a device manufacturing method comprising the steps of:
   - providing a substrate;
   - providing a projection beam of radiation using a radiation system;
   - using programmable patterning means to pattern the projection beam; and
   - projecting the patterned beam of radiation onto a target portion of the substrate;
   characterized by said programmable patterning means comprising a plurality of individually addressable pixels, each formed from a discrete element; and at least one pixel element comprises a layer of electro-optical material and electrodes for selectively
applying a voltage to the electro-optical material in order to change its birefringence;
said method further comprising the step of controlling each pixel element to modulate both the amplitude and phase of the radiation that is incident on it.

The term "programmable patterning means" as here employed should be broadly interpreted as referring to any means that can be used to endow an incoming radiation beam with a patterned cross-section, so that a desired pattern can be created in a target portion of the substrate; the terms "light valve" and "Spatial Light Modulator" (SLM) can also be used in this context. Examples of such patterning means include:
- A programmable mirror array. This may comprise a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate spatial filter, the said undiffracted light can be filtered out of the reflected beam, leaving only the diffracted light to reach the substrate; in this manner, the beam becomes patterned according to the addressing pattern of the matrix-addressable surface. An array of grating light valves (GLV) can also be used in a corresponding manner. Each GLV is comprised of a plurality of reflective ribbons that can be deformed relative to one another to form a grating that reflects incident light as diffracted light. A further alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the programmable patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference.
- A programmable LCD array. An example of such a construction is given in United States Patent US 5,229,872, which is incorporated herein by reference.

It should be appreciated that where pre-biasing of features, optical proximity correction features, phase variation techniques and multiple exposure techniques are used, the pattern "displayed" on the programmable patterning means may differ substantially from the pattern eventually transferred to a layer of or on the substrate.

For the sake of simplicity, the projection system may be referred to as the "lens"; however, this term should be broadly interpreted as encompassing various types of projection system, including refractive optics, reflective optics, catadioptric systems and micro lens arrays, for example. It is to be understood that the term "projection system" as used in this application simply refers to any system for transferring the patterned beam from the programmable patterning means to the substrate. The radiation system may also include components operating according to any of these design types for directing, shaping or controlling the projection beam of radiation, and such components may also be referred to below, collectively or singularly, as a "lens".

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the mask and the first element of the projection system. Immersion techniques are well known in the art for increasing the numerical aperture of projection systems.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, thin film transistor liquid crystal displays, printed circuit boards (PCBs), etc.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 run), as well as particle beams, such as ion beams or electron beams.

Exemplary embodiments of the invention will now be described, by way of example only, with reference to the accompanying schematic drawings, in which:
Figure 1 depicts a lithographic projection apparatus according to an embodiment of the invention;
Figure 2 depicts a pixel element of a programmable patterning means according to a first embodiment of the present invention;
Figure 3 depicts a variant of the embodiment shown in Figure 2; and
Figure 4 depicts a pixel element from a programmable patterning means according to a second embodiment of the present invention.

In the Figures, corresponding reference symbols indicate corresponding parts.

### Embodiment 1

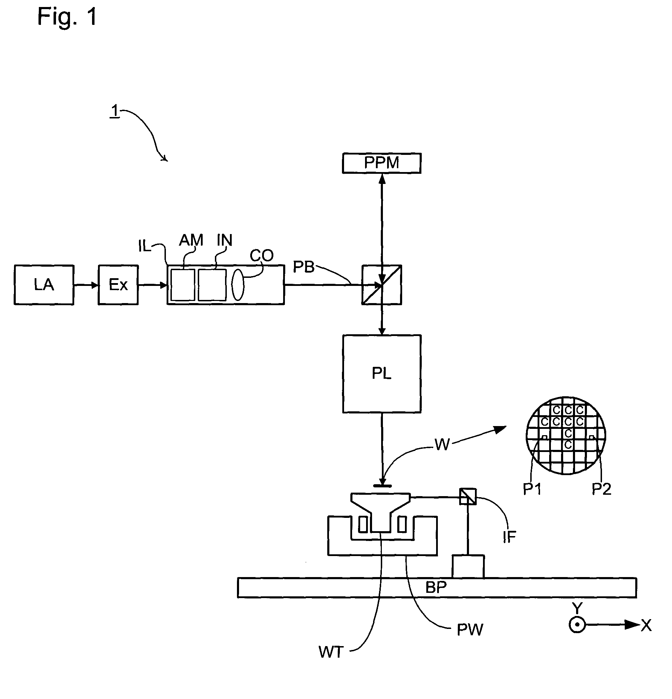

Figure 1 schematically depicts a lithographic projection apparatus according to a particular embodiment of the invention. The apparatus comprises:
- a radiation system Ex, IL, for supplying a projection beam PB of radiation (e.g. UV radiation), which in this particular case also comprises a radiation source LA;
- a programmable patterning means PPM (e.g. a programmable mirror array) for applying a pattern to the projection beam; in general the position of the programmable patterning means will be fixed relative to item PL; however it may instead be connected to a positioning means for accurately positioning it with respect to item PL;
- an object table (substrate table) WT provided with a substrate holder for holding a substrate W (*e.g.* a resist-coated silicon wafer), and connected to positioning means for accurately positioning the substrate with respect to item PL;
- a projection system ("lens") PL (*e.g.* a quartz and/or CaF₂ lens system or a catadioptric system comprising lens elements made from such materials, or a mirror system) for projecting the patterned beam onto a target portion C (*e.g.* comprising one or more dies) of the substrate W; the projection system may project an image of the programmable patterning means onto the substrate; alternatively, the projection system may project images of secondary sources for which the elements of the programmable patterning means act as shutters; the projection system may also comprise a micro lens array (known as an MLA), *e.g.* to form the secondary sources and to project microspots onto the substrate.

As here depicted, the apparatus is of a reflective type (*i.e.* has a reflective programmable patterning means). However, in general, it may also be of a transmissive type, for example (*i.e.* with a transmissive programmable patterning means).

The source LA (*e.g.* an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the programmable patterning means PPM has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the programmable patterning means PPM. Having been reflected by the programmable patterning means PPM, the beam PB passes through the projection system PL, which focuses the beam PB onto a target portion C of the substrate W. With the aid of the positioning means (and interferometric measuring means IF), the substrate table WT can be moved accurately, *e.g.* so as to position different target portions C in the path of the beam PB. Where used, the positioning means for the programmable patterning means can be used to accurately correct the position of the programmable patterning means PPM with respect to the path of the beam PB, *e.g.* during a scan. In general, movement of the object table WT is realized with the aid of a long-stroke module (course positioning) and a short-stroke module (fine positioning), which are not explicitly depicted in Figure 1. A similar system may also be used to position the programmable patterning means. It will be appreciated that the projection beam may alternatively/additionally be moveable while the object table and/or the programmable patterning means may have a fixed position to provide the required relative movement.

Although the lithography apparatus according to the invention is herein described as being for exposing a resist on a substrate, it will be appreciated that the invention is not limited to this use and the apparatus may be used to project a patterned projection beam for use in resistless lithography.

The depicted apparatus can be used in four preferred modes:
1. Step mode: the entire pattern on the programmable patterning means is projected in one go (i.e. a single "flash") onto a target portion C. The substrate table WT is then moved in the x and/or y directions to a different position for a different target portion C to be irradiated by the beam PB.
2. Scan mode: essentially the same as step mode, except that a given target portion C is not exposed in a single "flash". Instead, the programmable patterning means is movable in a given direction (the so-called "scan direction", e.g. the y direction) with a speed v, so that the projection beam PB is caused to scan over the programmable patterning means; concurrently, the substrate table WT is simultaneously moved in the same or opposite direction at a speed V = Mv, in which M is the magnification of the lens PL. In this manner, a relatively large target portion C can be exposed, without having to compromise on resolution.
3. Pulse mode: the programmable patterning means is kept essentially stationary and the entire pattern is projected onto a target portion C of the substrate using a pulsed radiation source. The substrate table WT is moved with an essentially constant speed such that the projection beam PB is caused to scan a line across the substrate W. The pattern on the programmable patterning means is updated as required between pulses of the radiation system and the pulses are timed such that successive target portions C are exposed at the required locations on the substrate. Consequently, the projection beam can scan across the substrate W to expose the complete pattern for a strip of the substrate. The process is repeated until the complete substrate has been exposed line by line.
4. Continuous scan mode: essentially the same as pulse mode except that a substantially constant radiation source is used and the pattern on the programmable patterning means is updated as the projection beam scans across the substrate and exposes it.

Combinations and/or variations on the above described modes of use or entirely different modes of use may also be employed.

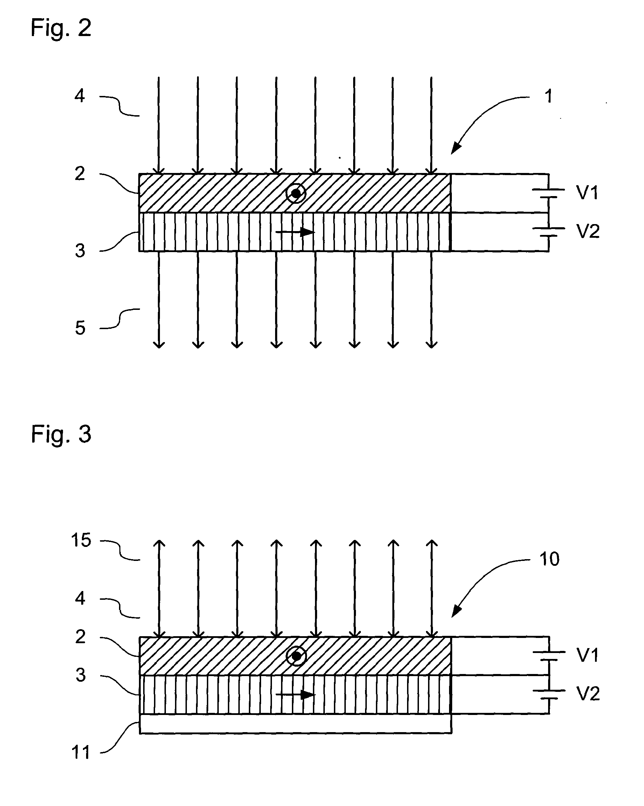

Figure 2 shows a pixel element 1 for use in an SLM of the type used in the present invention. In general, the SLM will be comprised of an array of such pixel elements. The array may, for example, contain between 1 and 8 million pixels, each between 5 and 10 µm across. The pixel element 1 is comprised of a first layer of electro-optical material 2 attached to a second layer of electro-optical material 3. The layers of electro-optical material 2, 3 function as uniaxial birefringent materials (with three orthogonal axes: two "ordinary" axes, in which the refractive index is a first value; and an "extraordinary" axis, sometimes referred to as the "optical axis", in which the refractive index is a second, different, value). Each layer of electro-optical material 2, 3 is oriented such that one of the ordinary axes is parallel to the optical axis of the lithographic apparatus, namely parallel to the direction of the radiation incident on the SLM in the situation shown in Figure 2. It will be appreciated, however, that, in some applications, the incident radiation may not be telecentric in which case the incident radiation will not be parallel to the optical axis of the lithographic apparatus. As shown in Figure 2, the layers of electro-optical material 2, 3 are oriented such that the extraordinary axis of the first layer of electro-optical material 2 is perpendicular to the extraordinary axis of the second layer of electro-optical material 3. Each of the layers of electro-optical material is provided with electrodes by which a voltage can be applied to the material. Voltage applied to the first layer 2 is designated V1 and the voltage applied to the second layer 3 is designated V2. The voltage applied to each layer, V1, V2, can be independently controlled.

The birefringence of the electro-optical layers 2, 3 is dependent on the voltage V1, V2, respectively, applied to each of the layers. Since the extraordinary axis of the two layers 2, 3 are mutually perpendicular, the ordinary ray (O-ray) in the first layer 2 becomes the extra-ordinary ray (E-ray) in the second layer 3 and vice versa. The birefringence of the materials causes the extra-ordinary ray to lag (or lead) with respect to the ordinary ray. The magnitude of the difference is dependent on the birefringence which, in turn, is dependent on the voltage applied. On the exit plane, therefore, there exists a phase difference between the ordinary rays and the extra-ordinary rays, this difference depending on the applied voltage. The result of this is a change in polarization. In the second layer 3 the role of the ordinary and extra-ordinary rays are exchanged. Therefore, if desired, a compensation of polarization change can take place. If the voltage V1, V2 applies to each of the layers 2, 3 is the same then the net change in polarization will be negligible. However, the resultant beam of radiation will have an overall phase change compared to a pixel element in which no voltage is applied to both layers. Therefore by applying equal voltages to both layers of a first pixel element and applying no voltage to both layers of an adjacent pixel element, the resultant radiation from both will not have any change in polarization but there will be a phase difference between the two. By applying a voltage to one layer but not the other, a change in polarization of the beam of radiation may be achieved. The phase change of the beam of radiation is dependent on the total voltage applied to both layers. Therefore by independently controlling the voltage applied to both layers, the pixel element 1 can control both the phase of the beam of radiation and the change in polarization. An offset voltage may be applied to both layers 2, 3. By increasing the voltage on one layer and decreasing the voltage on the other layer, the resultant beam of radiation from the pixel element will have the same phase as a beam of radiation from a pixel element with the offset voltages applied but the polarization of the beam of radiation will have been altered.

The radiation 4 incident on the pixel element 1 is polarized, either inherently as a result of the radiation system or by providing a polarizing filter between the radiation system and the SLM. The radiation 5 emitted from the pixel element 1 which is also polarized but the angle of the polarization is shifted by an amount dependent on the difference between the voltages V1, V2 applied to the electro-optical layers 2, 3. A second polarizing filter is located between the SLM and the substrate onto which the radiation is projected. The polarizing filter attenuates the intensity of the radiation by an amount that depends on the shift in polarization of the output beam of radiation 5. Therefore, by varying the degree of polarization shift within each pixel element, gray scales can be produced. In summary, by adjusting two voltages for each pixel element, each pixel element may have phase and amplitude modulation at the same time.

Figure 3 shows a variant of the embodiment shown in Figure 2 in which a reflective layer 7 is attached to the second electro-optical layer 3. The reflective layer 7 reflects the incident beam of radiation 4 back through the electro-optical layer, thus forming a reflective SLM which may be used in situations where it is not appropriate to use the transmissive SLM shown in Figure 2. Since the light passes through the electro-optical layers twice, the shift in amplitude and polarization provided by the electro-optical layer is, in effect, doubled. Consequently a smaller voltage may be applied to each of the layers to attain the same effect or the layers of electro-optical material can be thinner.

The efficiency of this variant of the first embodiment of the invention can be improved by providing an anti-reflection coating on the top face of the first electro-optical layer 2 and/or by providing a reflection enhancement coating between the reflected surface 11 and the second electro-optical layer 3.

The electro-optical layers may be formed from any well-known opto-electric materials, such as ADP, AD*P, KDP and KD*P. In order to obtain the best response from the electro-optical materials they should preferably be operated close to, but above, the Curie temperature of the material used. These generally are lower than ambient temperatures. KDP, for example, has a Curie temperature of 123K, KD*P has a Curie temperature variously reported as 213 or 222K and ADP has a Curie temperature of 148K. Consequently a temperature controlled cooling unit (not shown) may be provided to cool the electro-optical layers. Cooling may be applied by means of a cooling element in thermal contact with the electro-optical layers or by directing a flow of cooling gas onto the electro-optical layers.

### Embodiment 2

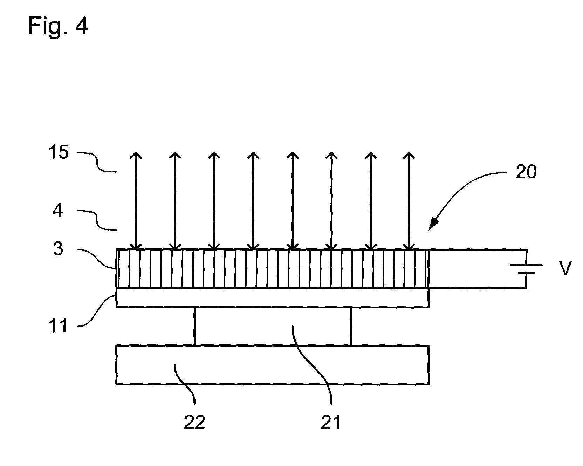

Figure 4 shows a pixel element 20 that may be used in an SLM for a lithographic projection apparatus according to the second embodiment of the invention. A single electro-optical layer 3 is provided. Electrodes attached to the layer are used to provide a voltage V to this layer. A reflective surface 11 is attached to the electro-optical layer 3. As in the first embodiment, a beam of radiation 4 is incident upon the pixel element 20, traverses the electro-optical layer 3, is reflected by the reflective layer 11, re-traverses the electro-optical layer 3 and is emitted from the pixel element as a beam of radiation 15. The voltage V applied to the electro-optical layer 3 may be used to adjust the shift in polarization of the beam of radiation. Again, by using a polarizing filter, controlling the polarizing shift can be used to effect gray scaling.

The electro-optical layer 3 and the reflective layer 11 are mounted on an actuator 21 which is controlled by electrodes 22. The actuator 21 may, for example, be effected using piezoelectric effect or electrostatic effects. The actuator 21 is used to control the position of the electro-optical layer 3 and the reflective layer 11 in a direction generally parallel to the incident beam of radiation (although when the beam is non- telecentric the movement will be at an angle to the direction of the beam of radiation). By adjusting the position of the electro-optical layer 3 and the reflective layer 11, the length of the beam path is altered, thereby allowing control of the phase of the radiation emitted from the pixel element. This may be used to produce a phase difference between the radiation emitted by adjacent pixels. It should be noted, that, since the variation in the birefringence of the electro-optical layer 3 caused by the changing of the voltage V will also induce a phase shift in the beam, it will be necessary to compensate for the phase shift induced by the electro-optical layer 3 using the actuator 21 in order to produce independent control of the phase and amplitude of the radiation produced by the pixel element 20.

Although the above embodiments have been described in the context of SLMs for patterning projection beams in lithographic projection apparatus, it will be appreciated that the present invention is not limited to this use and maybe used to create SLMs for other uses.

Whilst specific embodiments of the invention have been described above, it will be appreciated that the invention may be practiced otherwise than as described. The description is not intended to limit the invention.

## Claims

1. A lithographic projection apparatus comprising:
- a radiation system for providing a projection beam of radiation;
- programmable patterning means for patterning the projection beam according to a desired pattern;
- a substrate table for holding a substrate; and
- a projection system for projecting the patterned beam onto a target portion of the substrate;
**characterized in that** said programmable patterning means comprises a plurality of individually addressable pixels, each formed from a single discrete element that can be used to modulate both the amplitude and phase of the radiation that is incident on it; and at least one pixel element comprises a layer of electro-optical material and electrodes for selectively applying a voltage to the electro-optical material in order to change its birefringence.

2. A lithographic projection apparatus according to claim 1, wherein said at least one pixel element further comprises a second layer of electro-optical material and electrodes for selectively applying a second voltage to the second layer of electro-optical material in order to change its birefringence; and the extraordinary axis of said second layer is perpendicular to the extraordinary axis of the first layer.

3. A lithographic projection apparatus according to claim 1, wherein said at least one pixel element further comprises an actuator for adjusting the position of the pixel element in at least a direction parallel to the beam of radiation incident on it.

4. A lithographic projection apparatus according to any one of claims 1 to 3, further comprising a layer of reflective material attached to the electro-optical material of said at least one pixel element for reflecting the radiation transmitted through the electro-optical material.

5. A lithographic projection apparatus according to any one of the preceding claims, wherein at least one layer of electro-optical material is formed from one of ADP, AD*P, KDT and KD*P.

6. A lithographic projection apparatus according to any one of the preceding claims, further comprising a polarizing filter for attenuating the radiation from at least one pixel, dependent on its polarization.

7. A lithographic projection apparatus according to any one of the preceding claims, further comprising means for controlling the temperature of at least one layer of electro-optical material to be just above its Curie temperature.

8. Programmable patterning means comprising a plurality of individually addressable pixels, each formed from a single discrete element that can be used to modulate both the amplitude and phase of radiation that is incident on it; wherein at least one pixel element comprises a layer of electro-optical material and electrodes for selectively applying a voltage to the electro-optical material in order to change its birefringence.

9. A device manufacturing method comprising the steps of:
- providing a substrate;
- providing a projection beam of radiation using a radiation system;
- using programmable patterning means to pattern the projection beam; and
- projecting the patterned beam of radiation onto a target portion of the substrate;
**characterized by** said programmable patterning means comprising a plurality of individually addressable pixels, each formed from a discrete element; and at least one pixel element comprises a layer of electro-optical material and electrodes for selectively applying a voltage to the electro-optical material in order to change its birefringence; said method further comprising the step of controlling each pixel element to modulate both the amplitude and phase of the radiation that is incident on it.
